# EUROPÄISCHE PATENTANMELDUNG

(11) **EP 0 637 049 A1**
(43) Veröffentlichungstag der Anmeldung: **01.02.1995**
(21) Anmeldenummer: 94110377.2
(22) Anmeldetag: 04.07.1994
(51) Int. Cl.: H01J 9/02

(54) **Verfahren zur Herstellung einer elektrisch leitenden Spitze aus dotiertem Silizium und Anwendung des Verfahrens bei der Herstellung von Bauelementen der Vakuumelektronik**

(30) Priorität: 30.07.1993 DE 4325708
(71) Anmelder: SIEMENS AKTIENGESELLSCHAFT, D-80333 München (DE)
(72) Erfinder: Eisele, Ignaz, Prof., D-82057 Icking (DE); Baumgärtner, Hermann, Dr., D-80634 München (DE); Gossner, Harald, Dipl.-Phys., D-81735 München (DE); Risch, Lothar, Dr., D-85579 Neubiberg (DE)

(57) **Zusammenfassung**

Zur Herstellung einer elektrisch leitenden Spitze (7) aus dotiertem Silizium wird durch Molekularstrahlepitaxie aus dotiertem Silizium auf einem Substrat (1) aus monokristallinem Silizium innerhalb einer Öffnung (5) einer Maske die Spitze (7) aus dotiertem Silizium und auf der Oberfläche der Maske (4) eine dotierte Siliziumschicht (8) erzeugt. Die Spitze ist insbesondere als Feldemissionskathode für Bauelemente der Vakuumelektronik geeignet.

## Beschreibung

Für Bauelemente der Vakuummikroelektronik ist es erforderlich, elektrisch leitende Spitzen mit kleinen Abmessungen herzustellen. Diese Spitzen haben die Form einer Pyramide mit einer Höhe von etwa 1 um und einer Basisfläche von etwa 1 x 1 µm². Derartige Spitzen werden auch als Tunnelspitzen verwendet. Sie werden insbesondere aus dotiertem Silizium hergestellt.

Es ist bekannt, elektrisch leitende Spitzen mit Hilfe der Mikromechanik herzustellen (siehe zum Beispiel Heuberger, Mikromechanik, Springer Verlag, S. 426 - 428). Die Spitzen werden zum Beispiel durch kristallorientierungsabhängiges, anisotropes Ätzen hergestellt. Dazu wird eine Siliziumscheibe mit entsprechender Kristallorientierung mit einer Oxidmaske versehen, die eine Matrix kreisförmiger Siliziumoxidflecken aufweist. Bei dem anisotropen Ätzen entstehen unter den Siliziumoxidflecken durch Unterätzung Pyramiden mit einem Öffnungswinkel von etwa 70°.

Aus Heuberger, Mikromechanik, Springer Verlag, S. 426 - 428, ist ferner ein Verfahren bekannt, mit dem eine leitfähige Spitze aus Metall herstellbar ist. Dabei wird auf ein Siliziumsubstrat eine Maske mit kreisförmigen Öffnungen gebildet. Durch gerichtetes Aufdampfen von Molybdän in Richtung der Normalen und senkrecht dazu und Drehung des Siliziumsubstrats bilden sich innerhalb der Öffnungen der Maske pyramidenförmige Metallinseln.

Zur Herstellung eines kompletten Bauelements sind in diesen bekannten Verfahren weitere Maskenschritte oder hybride Technologien erforderlich.

Aus DE 40 41 276 C1 ist bekannt, eine elektrisch leitende Spitze aus dotiertem Silizium durch selektive Epitaxie herzustellen. Dabei wird eine Maske mit einer Öffnung erzeugt, in der die Oberfläche des Substrats freiliegt. Auf der freiliegenden Oberfläche wird die elektrisch leitende Spitze durch eine selektive Epitaxie erzeugt, bei der das Schichtwachstum in Richtung parallel zur Oberfläche des Substrats geringer ist als in Richtung senkrecht zur Oberfläche des Substrats. Sobald die Höhe der Spitze größer ist als die halbe Weite der Öffnung, entsteht in diesem Verfahren eine punktförmige Spitze. Bei diesem Verfahren ist die Höhe der Spitze abhängig von den Abmessungen der Öffnung der Maske.

Der Erfindung liegt das Problem zugrunde, ein Verfahren zur Herstellung einer elektrisch leitenden Spitze aus dotiertem Silizium anzugeben, bei dem die Hohe der Spitze weitgehend unabhängig von Abmessungen einer verwendeten Maske ist. Das Verfahren soll insbesondere geeignet sein zur gleichzeitigen selbstjustierten Herstellung von weiteren Elektroden zum Aufbau eines kompletten Vakuummikroelektronikbauelementes.

Dieses Problem wird erfindungsgemäß gelost durch ein Verfahren nach Anspruch 1. Weitere Ausgestaltungen der Erfindung gehen aus den übrigen Ansprüchen hervor.

Die Erfindung macht sich die Erkenntnis zunutze, daß bei der Molekularstrahlepitaxie von Silizium auf einer Siliziumoberfläche, die von einer Maske umgeben ist, auch lokale Molekularstrahlepitaxie genannt, in einem selbstorganisierenden Wachstumsprozeß eine Pyramide entsteht. Die Ursache für die Ausbildung der Pyramide liegt in dem Bestreben eines Kristalls, freie Oberflächen mit minimaler Oberflächenenergie zu erzeugen. Die Ausbildung von (111)-Oberflächen ist gegenüber der Ausbildung von (110)-bzw. (100)-Oberflächen begünstigt. Wird eine Kante der Maske auf einem (100)-Substrat in der [110]-Richtung orientiert, so bilden sich aus diesem Grund bevorzugt (111)-Oberflächen aus, die die Seitenflächen der Pyramide bilden. Da die Länge der Pyramidenflächen durch die Oberflächendiffusion der Atome begrenzt ist, ist es vorteilhaft, die Maskenöffnung vergleichbar mit dieser Diffusionslänge zu wählen.

Gleichzeitig mit dem Entstehen der pyramidenförmigen Spitze innerhalb der Maskenöffnung wird bei der Molekularstrahlepitaxie auf der Oberfläche der Maske eine dotierte Siliziumschicht abgeschieden. Diese wächst polykristallin oder amorph auf. Die dotierte Siliziumschicht wachst selbstjustiert auf. Sie ist als Anode geeignet in einem Bauelement, in dem die Spitze als Feldemissionskathode verwendet wird.

Durch selektives Abscheiden einer leitfähigen Schicht auf der Oberfläche der dotierten Siliziumschicht und der Spitze wird die Leitfähigkeit dieser Strukturen verbessert.

Es liegt im Rahmen der Erfindung, die Maske aus einer Schichtenfolge aus isolierenden Schichten und mindestens einer dazwischen angeordneten elektrisch leitenden Schicht herzustellen. Die elektrisch leitende Schicht kann als Gitterelektrode für eine Feldemissionskathodenröhre verwendet werden.

Zur Herstellung der Maske wird auf das Substrat eine erste Schicht aus einem ersten Isolator, z. B. SiO₂, darauf eine zweite Schicht aus elektrisch leitendem Material und darauf eine dritte Schicht aus einem zweiten Isolator, z. B. Si₃N₄ aufgebracht. Zur Bildung der Maskenöffnung werden die dritte Schicht und die zweite Schicht in einem anisotropen Ätzprozeß strukturiert. Die erste Schicht wird anschließend in einem isotropen Ätzprozeß selektiv zur zweiten Schicht und zur dritten Schicht so strukturiert, daß die Oberfläche des Substrats freigelegt wird und daß eine Unterätzung der ersten Schicht unter die Kanten der zweiten Schicht entsteht. Die elektrisch leitende Spitze, die bei der Molekularstrahlepitaxie auf der Oberfläche des Substrats aufgewachsen wird, ist durch die erste Schicht von der zweiten, als Gitter verwendbaren Schicht isoliert. Die zweite Schicht ist wiederum von der dotierten Siliziumschicht, die auf der Oberfläche der dritten Schicht entsteht, durch die dritte Schicht isoliert.

Es ist besonders vorteilhaft, ein Substrat aus (100)-Silizium zu verwenden. Die Maskenöffnung muß dann quadratisch sein und in [110]-Richtung orientiert sein.

Im folgenden wird die Erfindung anhand eines Beispiels und der Figuren näher erläutert.
- Figur 1: zeigt ein Substrat mit einer ersten Schicht, einer zweiten Schicht und einer dritten Schicht für eine Maske.
- Figur 2: zeigt das Substrat nach der anisotropen Strukturierung der dritten Schicht und der zweiten Schicht.
- Figur 3: zeigt das Substrat nach Fertigstellung der Maske durch isotropes Ätzen der ersten Schicht.
- Figur 4: zeigt das Substrat nach der Molekularstrahlepitaxie.
- Figur 5: zeigt das Substrat nach der Abscheidung leitfähiger Schichten.

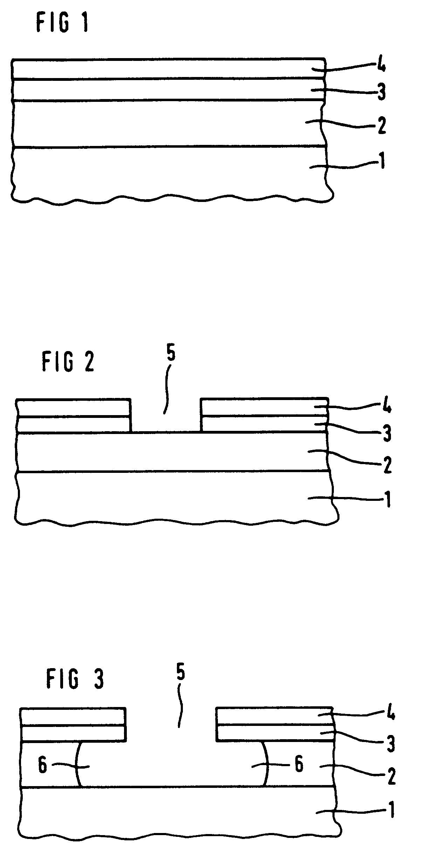

Auf ein Substrat 1 aus (100)-Silizium wird eine erste Schicht 2 aus SiO₂ aufgebracht (siehe Figur 1). Die erste Schicht 2 wird zum Beispiel durch CVD-Abscheidung in einer Dicke von zum Beispiel 1 µm hergestellt. Auf die erste Schicht 2 wird eine zweite Schicht 3 aus einem elektrisch leitenden Material aufgebracht. Die zweite Schicht 3 wird zum Beispiel aus hochdotiertem Polysilizium in einer Dicke von 300 nm durch CVD-Abscheidung hergestellt. Auf die zweite Schicht 3 wird eine dritte Schicht 4 aus Si₃N₄ aufgebracht. Die dritte Schicht 4 wird zum Beispiel durch eine CVD-Abscheidung in einer Dicke von 100 nm hergestellt.

Unter Verwendung einer Photolackmaske (nicht dargestellt) werden die dritte Schicht 4 und die zweite Schicht 3 in einem anisotropen Ätzprozeß strukturiert. Dabei wird eine Öffnung 5 erzeugt, die parallel zur Oberflache des Substrats 1 einen quadratischen Querschnitt aufweist (siehe Figur 2) . In einem isotropen Ätzprozeß mit zum Beispiel gepufferter Flußsäure (HF) wird die erste Schicht 2 selektiv zur zweiten Schicht 3, dritten Schicht 4 und zur Oberflache des Substrats 1 geätzt. Dadurch wird die Öffnung 5 in vertikaler Richtung bis zur Oberfläche des Substrats 1 vergrößert (siehe Figur 3). Gleichzeitig werden Unterätzungen 6 der ersten Schicht 2 unter die Kante der zweiten Schicht 3 gebildet, so daß der Querschnitt der Öffnung 5 an der Oberfläche des Substrats 1 den Querschnitt der Öffnung 5 im Bereich der zweiten Schicht 2 und der dritten Schicht 4 seitlich überragt.

Die quadratische Öffnung ist in [110]-Richtung des Substrats 1 aus (100)-Silizium orientiert. Die quadratische Öffnung 5 weist an der Oberfläche des Substrats eine Seitenlange von etwa 1 - 2 µm auf. Im Bereich der zweiten Schicht 3 und der dritten Schicht 4 weist die quadratische Öffnung 5 eine Seitenlänge von zum Beispiel 300 nm auf.

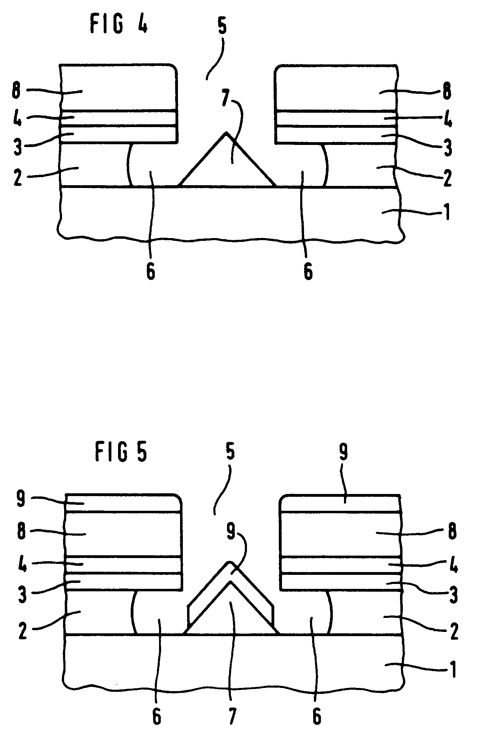

Durch Molekularstrahlepitaxie von dotiertem Silizium wird anschließend auf der freiliegenden Oberfläche des Substrats 1 eine Spitze 7 aufgewachsen. Gleichzeitig wird auf der Oberfläche der dritten Schicht 4 eine dotierte Siliziumschicht 8 abgeschieden. Die Molekularstrahlepitaxie wird bei einer Substrattemperatur während des Epitaxieprozesses zwischen 400°C und 700°C und mit einer Aufdampfrate zwischen 0,1Å/sec und 5Å/sec durchgeführt. Die Spitze 7 wächst aufgrund eines physikalisch bedingten selbstorganisierenden Wachstumsprozesses als Pyramide auf, deren Seitenflächen (111)-Flächen sind (siehe Figur 4). Die Spitze 7 weist eine Höhe von zum Beispiel 400 nm auf. Die dotierte Siliziumschicht 8 wächst amorph oder polykristallin auf und wird in einer Dicke von zum Beispiel 400 nm abgeschieden. Die Dotierstoffkonzentration beträgt 10¹⁹ cm⁻³.

Zur Verbesserung der elektrischen Leitfähigkeit der dotierten Siliziumschicht 8 und der Spitze 7 wird anschließend selbstjustierend eine leitfähige Schicht 9 abgeschieden. Die leitfähige Schicht 9 wird zum Beispiel durch Wolframabscheidung in einer Dicke von zum Beispiel 100 nm hergestellt.

Die in Figur 9 dargestellte Halbleiterstruktur kann als Feldemissionsröhre verwendet werden. Die Spitze 7 mit der leitfähigen Schicht 9 dient als Emitter, die zweite Schicht aus elektrisch leitendem Material als Gitter und die dotierte Siliziumschicht 8 mit der leitfähigen Schicht 9 als Anode. Zur Herstellung dieser Struktur ist nur ein Maskenschritt erforderlich. In diesem Bauelement können die Gitterebenen durch Variation der Schichtdicken und Schichtfolgen in der aus der ersten Schicht 2, der zweiten Schicht 3 und der dritten Schicht 4 gebildeten Maske frei gewählt werden.

## Patentansprüche

1. Verfahren zur Herstellung einer elektrisch leitenden Spitze aus dotiertem Silizium,
- bei dem auf ein Substrat (1) aus monokristallinem Silizium eine Maske (2, 3, 4) erzeugt wird,
- bei dem die Maske (2, 3, 4) eine Maskenöffnung (5) aufweist, in der die Oberfläche des Substrats (1) freiliegt und deren Querschnitt an der Oberfläche des Substrats (1) den Querschnitt an der Oberfläche der Maske (4) überragt,
- bei dem durch Molekularstrahlepitaxie von dotiertem Silizium auf der freiliegenden Oberfläche des Substrats (1) die Spitze (7) aus dotiertem Silizium erzeugt wird und auf der Oberfläche der Maske (4) eine dotierte Siliziumschicht (8) abgeschieden wird.

2. Verfahren nach Anspruch 1,
bei dem auf die Oberfläche der dotierten Siliziumschicht (8) und der Spitze (7) jeweils eine Metallschicht (9) abgeschieden wird.

3. Verfahren nach Anspruch 1 oder 2,
- bei dem zur Herstellung der Maske auf das Substrat (1) eine erste Schicht (2) aus einem ersten Isolator, darauf eine zweite Schicht (3) aus elektrisch leitendem Material und darauf eine dritte Schicht (4) aus einem zweiten Isolator aufgebracht wird,
- bei dem zur Bildung der Maskenöffnung (5) die dritte Schicht (4) und die zweite Schicht (3) in einem anisotropen Ätzprozeß strukturiert werden,
- bei dem die erste Schicht (2) in einem isotropen Ätzprozeß selektiv zur zweiten Schicht (3) und zur dritten Schicht (4) so strukturiert wird, daß die Oberfläche des Substrats (1) freigelegt wird und daß eine Unterätzung der ersten Schicht (2) unter die Kanten der zweiten Schicht (3) entsteht.

4. Verfahren nach Anspruch 2 oder 3,
bei dem für die erste Schicht (2) SiO₂, für die zweite Schicht (3) dotiertes Polysilizium, für die dritte Schicht (4) Si₃N₄ und für die leitfähige Schicht (9) dotiertes Polysilizium oder Wolfram verwendet wird.

5. Verfahren nach einem der Ansprüche 1 bis 4,
- bei dem das Substrat (1) aus (100)-Silizium besteht,
- bei dem die Maskenöffnung (5) quadratisch ist und in [110]-, [101]- oder [011]-Richtung orientiert ist.

6. Verfahren nach Anspruch 5,
bei dem die Molekularstrahlepitaxie bei einer Substrattemperatur während des Epitaxieprozesses zwischen 400°C und 700°C und mit einer Aufdampfrate zwischen 0,1Å/sec und 5Å/sec durchgeführt wird.

7. Anwendung des Verfahrens nach einem der Ansprüche 1 bis 6
zur Herstellung einer Feldemissionskathode für ein Bauelement der Vakuumelektronik.
